# EUROPEAN PATENT APPLICATION

(11) **EP 2 983 209 A1**
(43) Date of publication of application: **10.02.2016**
(21) Application number: 14180193.6
(22) Date of filing: 07.08.2014
(51) Int. Cl.: H01L 27/32, H01L 51/52, H01L 51/56, H01L 51/00

(54) **Organic electronics device, method and system for producing the same**

(71) Applicant: Koninklijke Philips N.V., 5656 AE Eindhoven (NL)
(72) Inventor: The designation of the inventor has not yet been filed
(74) Representative: van Dijken, Albert

(57) **Abstract**

The invention relates to an organic electronics device, to a method for producing such organic electronics device and to a system for producing such organic electronics device as well as to a software product for controlling such system. In order to provide a simple and cost-effective implementation of an organic electronics device including interconnected organic electronics segments with improved shelf and operation lifetime, it is proposed that one single or multiple adjacent isolation layers (17) are provided on a plurality of organic electronics segments (11), with contacting material (19) electrically contacting a respective one of the electrodes (12, 14) of one organic electronics segment (11) with a respective one of the electrodes (14, 12) of another organic electronics segment (11) in respective through-holes (18).

## Description

### FIELD OF THE INVENTION

The invention relates to an organic electronics (e.g. OLED or OPVC) device, to a method for producing such organic electronics device and to a system for producing such organic electronics device as well as to a software product for controlling such system.

### BACKGROUND OF THE INVENTION

Organic light emitting devices (OLED) are seeing increased use in digital displays and lighting applications. Organic photovoltaic cells (OPVC) are similarly seeing increased use in the context of producing electric power from sunlight.

OLED devices and OPVC devices, however, are very sensitive to moisture and oxygen, which can cause severe device degradation. In order to ensure a long shelf and operation lifetime, for example, OLED devices are provided with a high quality thin-film encapsulation (TFE). Such films are often comprised of single inorganic or inorganic/organic multilayer stacks. Even though the intrinsic barrier properties of such thin-film encapsulation approaches show a sufficient protection against moisture and oxygen, extrinsic barrier properties due to pin-holes, voids, particles or contamination might limit the overall barrier quality. Such imperfections represent penetration pathways for water and oxygen through the TFE which deteriorate the barrier quality. The pin-hole size within a TFE is normally very small; however, water and/or oxygen will slowly penetrate through these pin-holes and cause a degradation of the OLED device at this spot. Over time, this degraded spot may grow and affect even the entire device area. In a similar manner, OPCV device may be negatively affected.

Another important topic is related to the electrical connection of an OLED (as an example of an organic electronics) to a power source. In general, OLED devices are operated at low voltages ranging from 3V to 15V. Thus, additional power converters are needed to couple to the AC grid connection. These power converters are often inefficient and costly for the demanded voltage range. A promising strategy to overcome the use of power converters is an electrical connection in serial of individual OLED devices on a common substrate which leads to higher overall device operating voltage. Another advantage of a serial connection is that electrical shorts in a segmented OLED device can only deteriorate single elements. The remaining OLED elements in the series can continue to emit light. Thus, a serial connection of OLED devices can drastically improve the production yield.

US 2012/0248472 A1 discloses a method for creating serially connected OLED segments, where adjacent OLED segments are separated by a trench between them formed by ablating material, wherein furthermore such trench is at least partially filled with an electrically conductive material for connecting the OLED segments in series. Prior to the applying of the electrically conductive material interconnecting the separated OLED segments an insulating material may be applied at least partially in order to avoid short circuits.

### SUMMARY OF THE INVENTION

It is an object of the present invention to provide a simple and cost-effective implementation of an organic electronics device including interconnected organic electronics segments with improved shelf and operation lifetime. Examples of organic electronics devices are OLED devices and OPVC devices.

In a first aspect of the present invention, an organic electronics device is presented, comprising a substrate, a plurality of organic electronics segments commonly arranged on the substrate, each organic electronics segment comprising an organic electronics element and a top electrode and a bottom electrode, one single or multiple adjacent isolation layers on the plurality of organic electronics segments, and contacting material electrically contacting a respective one of the electrodes of one organic electronics segment with a respective one of the electrodes of another organic electronics segment, wherein each isolation layer has at least one through-hole allowing for a contacting of the contacting material with the electrode of the organic electronics segment, the isolation layer otherwise electrically isolating the contacting material and the organic electronics segments.

In a second aspect of the present invention, a method for producing an organic electronics device is presented, comprising the steps providing a plurality of organic electronics segments commonly arranged on a substrate, each organic electronics segment comprising an organic electronics element and a top electrode and a bottom electrode, arranging one single or multiple adjacent isolation layers on the plurality of organic electronics segments, and electrically contacting a respective one of the electrodes of one organic electronics segment with a respective one of the electrodes of another organic electronics segment by applying contacting material, wherein the step of arranging is carried out such that each isolation layer has at least one through-hole allowing for a contacting of the contacting material with the electrode of the organic electronics segment, the isolation layer otherwise electrically isolating the contacting material and the organic electronics segments, and wherein the step of contacting is carried out such that the contacting material contacts the electrode in the through-hole.

In a third aspect of the present invention, a system for producing an organic electronics device is presented, comprising segment providing means for providing a plurality of organic electronics segments commonly arranged on a substrate, each organic electronics segment comprising an organic electronics element and a top electrode and a bottom electrode, arranging means for arranging one single or multiple adjacent isolation layers on the plurality of organic electronics segments, contacting means for electrically contacting a respective one of the electrodes of one organic electronics segment with a respective one of the electrodes of another organic electronics segment by applying contacting material, and a controller for controlling the segment providing means, the arranging means and the contacting means, wherein the arranging means is configured to be controlled by the controller to arrange the single or multiple adjacent isolation layers such that each isolation layer has at least one through-hole allowing for a contacting of the contacting material with the electrode of the organic electronics segment, the isolation layer otherwise electrically isolating the contacting material and the organic electronics segments, wherein the contacting means is configured to be controlled by the controller to carry out the contacting such that the contacting material contacts the electrode in the through-hole.

It was realized that the one or more isolation layers may not only function in terms of avoiding short circuits between contacting material and electrodes but may additionally be used for improving the shelf and operation lifetime of the organic electronics device, for example, in increasing the length of a leakage path moisture or oxygen has to take inside the organic electronics device before reaching sensitive elements, in directing any leakage away from a particularly sensitive portion (or a portion where a so called "black spot" resulting from damage due to moisture and/or oxygen would be particular detrimental or conspicuous), or generally reducing the immediate impact of, for example, a pinhole in the encapsulation (typically provided in TFE) by spreading the introduced moisture and/or oxygen throughout the respective one of the multiple isolation layers.

It is part of the invention to realize that the overall coverage and resulting improvement can be provided without endangering the necessary electrical contacting between the organic electronics segments by providing through-holes or openings in the isolation layer(s), allowing for the contacting between contacting material and electrode.

In a preferred embodiment, the one isolation layer is provided on the plurality of the organic electronics segments having at least one through-hole for each top electrode of the plurality of organic electronics segments and at least one through-hole for each bottom electrode of the plurality of organic electronics segments, wherein preferably the isolation layer is impermeable to moisture and/or oxygen.

Particularly in case of an isolation layer being impermeable to moisture and/or oxygen, it is beneficial to cover basically the whole plurality of organic electronics segments with the same continuous isolation layer, having through-hole only in selected positions needed for contacting. Even though, due to the through-hole such continuous isolation layer may not be an encapsulation in its strictest sense, nevertheless the travel path for moisture and/or oxygen is greatly increased in length. An example for such impermeable isolation layer may be made of SiN.

In another preferred embodiment, each of the multiple isolation layers is respectively provided on one or more of the plurality of organic electronics segments and is separated from an adjacent isolation layer provided on the same or a different of the plurality of organic electronics segments. Here, the multiple isolation layers may even be permeable to moisture and/or oxygen, while then each of the multiple isolation layers preferably further includes getter material for absorbing moisture and/or oxygen.

The diffusion of the moisture and/or oxygen in the respective isolation layer results in a longer time needed for the concentration of moisture and/or oxygen reaching a critical level, whereas this is even further improved by the provision of getter material.

The separation of the multiple isolation layers from each other avoids or reduces the spreading of introduced moisture or oxygen throughout the organic electronics device.

Current materials used in printing isolation layers may be used in this context.

In a preferred embodiment, the organic electronics segments of the plurality of organic electronics segments are arranged in rows and columns, with the organic electronics segments being electrically connected in parallel column-wise and being electrically connected in series row-wise.

The provision of such grid-like pattern gives a two-fold advantage. As discussed above, the connection of organic electronics segments in series allows for a higher operation voltage. Furthermore, the parallel separation of the organic electronics segments further reduces the impact of defects in an organic electronics segment. For example, an electrical short in one organic electronics segment does not significantly affect the other organic electronics segments in the same column.

It is to be noted that the arrangement in rows and columns does not necessarily have to be a strict arrangement of segments of identical size in straight rows and columns, as irregularities in the arrangement are also possible.

In a preferred embodiment, the step of providing the plurality of organic electronics segments includes segmenting the plurality of organic electronics segments by selectively removing portions from an unstructured semi-finished arrangement of an organic electronics element, a top electrode and a bottom electrode.

A drawback of using serial connection using conventional production approaches is the high manufacturing costs due to expensive and complex lithography pattering of the substrate.

A simplified and cost-saving implementation of a serial organic electronics connection along with a higher production yield can be realized by a segmentation process which is accomplished after manufacturing the organic electronics via a material removal process.

In a preferred embodiment, the step of arranging the one single or multiple adjacent isolation layers includes selectively removing portions from the isolation layer or layers to provide the through-hole and/or a separation of adjacent isolation layers.

It is possible to avoid additional costs or efforts otherwise needed for a structured application of the isolation material to form the single or multiple adjacent isolation layers having through-holes by removing the respective portions from a previously provided continuous isolation layer.

In a preferred embodiment, the step of electrically contacting the electrodes includes selectively removing contacting material.

The pattern of electrical contacting material for contacting the multiple organic electronics segments may not only be achieved by selectively applying the contacting material but also by providing a "blanket" of contacting material (e.g. a more or less continuous layer indiscriminately covering one or more segments), from which undesired portions are removed.

The present invention gives in this context the additional benefit that a process like "thermal evaporation", which is difficult to control exactly in terms of position, may be used nevertheless without imposing undesirable limitation on the resulting organic electronics device.

In US 2012/0248472 A1 the connecting conductive material is provided the trench between the OLED segments. As hitting such trench becomes more and more difficult with smaller size of the trench (i.e. with smaller distance between adjacent OLED segments), the use of thermal evaporation would significantly limit the options in reduction of the trench size. In the context of the present invention, it is not necessary to control the thermal evaporation to the same extent, as the isolation layer acts as an electrical protection of the neighboring organic electronics segment when applying the connecting material.

In a further aspect of the present invention, a software product or computer program is presented for producing an organic electronics device, the software product comprising program code means for causing a controller of the system according to the present invention to carry out the steps of the method according to the present invention when the software product is run on the controller.

The organic electronics element may be, for example, in the case of an OLED device an OLED stack or layer, or, in the case of an OPVC device, similarly, a single or multilayer arrangement.

It shall be understood that the organic electronics device of claim 1, the method for producing an organic electronics device of claim 7, the system for producing an organic electronics device of claim 11, and the computer program of claim 12 have similar and/or identical preferred embodiments, in particular, as defined in the dependent claims.

It shall be understood that a preferred embodiment of the invention can also be any combination of the dependent claims or above embodiments with the respective independent claim.

These and other aspects of the invention will be apparent from and elucidated with reference to the embodiments described hereinafter.

### BRIEF DESCRIPTION OF THE DRAWINGS

In the following drawings:
Figs. 1A to 1E show schematic illustrations for steps of the manufacturing of an OLED device and such OLED device in accordance with an embodiment of the invention,
Fig. 2 shows a schematic illustration of an OLED device in accordance with an embodiment of the invention,
Fig. 3A and 3B show a schematic illustration of an electrical connection between OLED segments in accordance with embodiments of the invention,
Fig. 4 shows a flow diagram illustration a method for producing an OLED device in accordance with an embodiment of the invention and
Fig. 5 shows a schematic illustration of a system for producing an OLED device in accordance with an embodiment of the invention.

### DETAILED DESCRIPTION OF EMBODIMENTS

In the present description of embodiments, referral is made to an OLED device, the method of producing such OLED device and a system for producing such OLED device. The skilled person appreciates that this is merely an example of a particular kind of organic electronics device and that the content of the following discussion might easily be adopted for other kind of organic electronics, like for example and OPVC device.

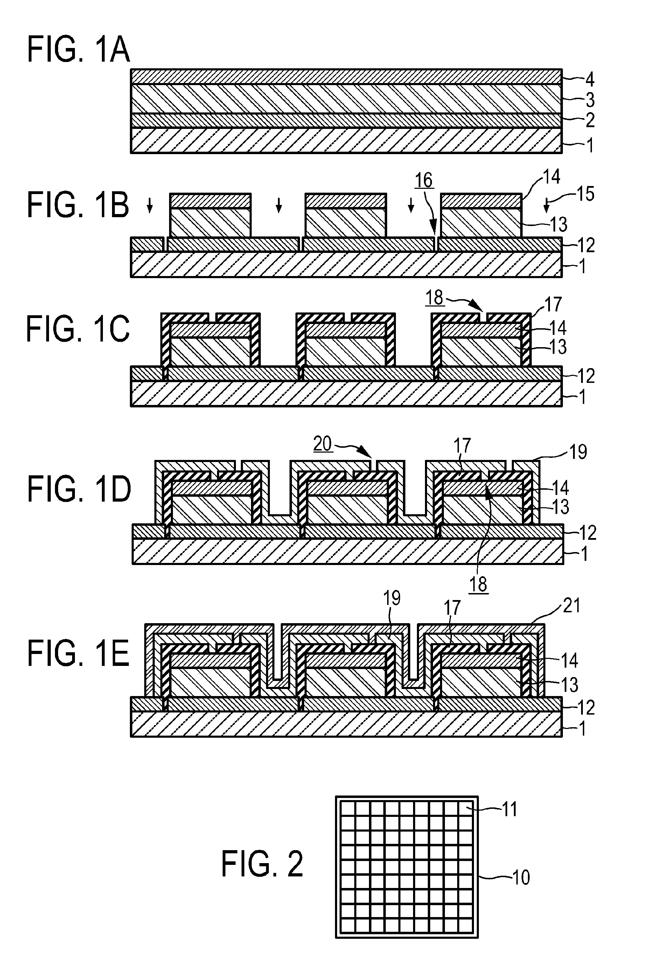

Figs. 1A to 1E show schematic illustrations for steps of the manufacturing of an OLED device and such OLED device in accordance with an embodiment of the invention.

According to a preferred embodiment as illustrated in Fig. 1A to 1E, the process of manufacturing starts with an unstructured OLED arrangement on a substrate that is covered with an unstructured transparent electrode. Therefore, no masks are required during the OLED manufacturing process. On the substrate 1, an unstructured bottom electrode 2, an unstructured OLED stack 3 (as an example of an organic electronics element) and an unstructured top electrode 4 are provided (see Fig. 1A).

A material removing technique such as laser ablation or etching is used to pattern the OLED arrangement into multiple segments which are electrical disconnected from each other. In Fig. 1B, the material removal is indicated by arrows 15.

The result of the material removal is the provision of multiple adjacent OLED segments, each comprising a bottom electrode 12, an OLED stack 13 and a top electrode 14, arranged on a common substrate 1 (see Fig. 1B).

While between the OLED stacks 13 and the top electrode 14, respectively, sufficient distance is provided to allow for the subsequent provision of the isolation layers and, metal layers for connection and a TFE layer for encapsulation (see Fig. 1E), the adjacent bottoms electrodes are just separated by a comparatively small gap 16.

Then, adjacent isolation layers 17 are applied (for example by ink-jet printing, plasma-enhanced chemical vapor deposition PECVD, sputtering or atomic layer deposition ALD) so that basically each OLED segment is covered, but leaving an opening 18 to the top electrode 14 and having gaps at the bottom electrode 12 of each OLED segment, as illustrated in Fig. 1C. The isolation layers 17 extend into the gaps 16 between the bottom electrodes 12 to isolate these electrodes from each other.

In a process like ink-jet printing, the openings or through-holes 18 may be provided directly by not applying material to such portion, while alternatively (or additionally) portions of the applied isolation material may selectively be removed in order to provide the through-holes and/or gaps.

Subsequent (see Fig. 1D) a metal layer 19 is applied in a way that a bottom electrode 12 of one OLED segment and a top electrode 14 of an adjacent OLED segments are electrically connected, thus forming a serial connection. The metal layer 19, as example for connecting material, is provided with gaps 20 such that the respective portions of the layer 19 are separated and electrically unconnected.

Finally, a thin film encapsulation 21 is deposited, as shown in Fig. 1E, comprising one layer or multiple layers to protect the device against the environment.

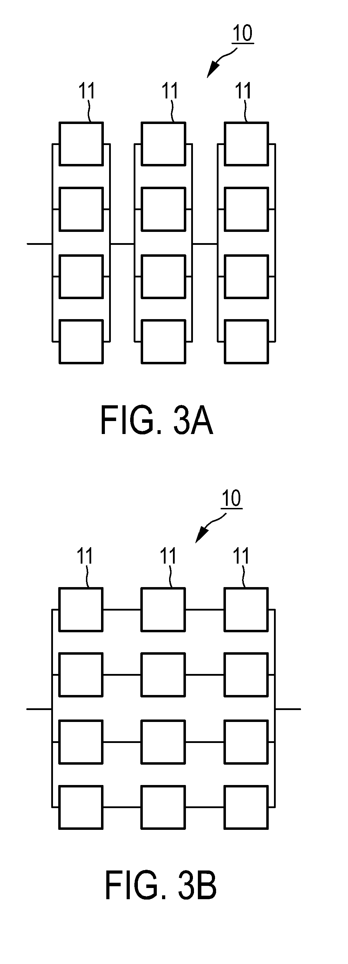

The final device consists of multiple OLED segments 11 on a common substrate 1 where columns of segments 11 are connected in parallel and rows are connected in serial, or vice versa, as it is shown in Fig. 2, Fig. 3A and Fig. 3B.

Two exemplary embodiments of interconnections are shown in Fig 3A and 3B.

In Fig. 3A, the respective OLED segments 11 of one column are all connected in parallel, while such parallel connected column of OLED segments 11 in connected in series to the adjacent column.

Fig. 3B shows a different arrangement, where the OLED segments 11 of a row are connected in series, while furthermore the separate rows of OLED segments 11 are connected in parallel.

It is to be noted that localized defects in the thin film encapsulation can only deteriorate the corresponding OLED segment. The defect will degrade over time the OLED segment, but since each segment has a fully closed thin film encapsulation, the degraded spot cannot affect neighboring segments due to the presence of an isolating barrier gap according to this invention.

A localized short due to contaminations, particles or pin-holes can only affect one OLED segment. All other devices in a serial connection will continue operation. Thus, a serial connection of OLED devices can drastically improve the production yield.

Repairing of defects and shorts is less critical, because of a confined area.

Serial connections of OLED segments allow for an operation at higher voltages, making coupling to the AC grid feasible without the use of inefficient and costly power converters.

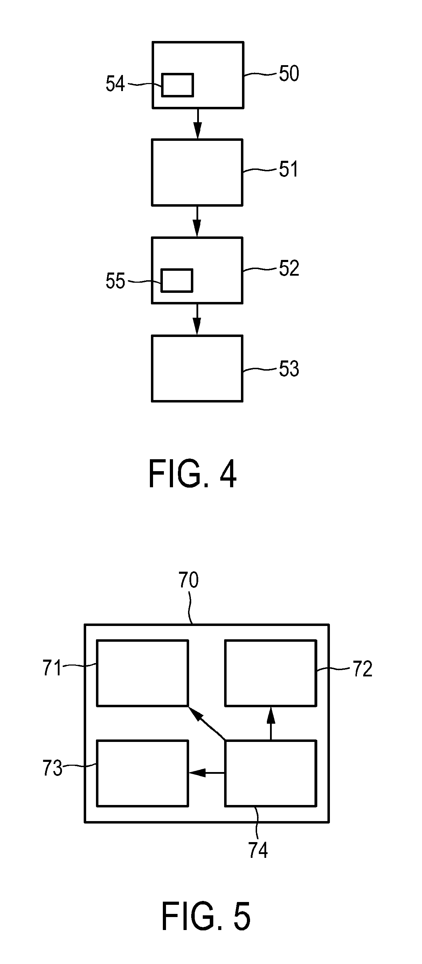

Fig. 4 shows a flow diagram illustration a method for producing an OLED device in accordance with an embodiment of the invention.

In a providing step 50, a plurality of OLED segments commonly arranged on a substrate are prepared, each OLED segment comprising an OLED stack and a top electrode and a bottom electrode. As a sub-step of the providing step 50, a segmenting step 54 of segmenting the plurality of OLED segments by selectively removing portions from an unstructured semi-finished arrangement of an OLED stack, a top electrode and a bottom electrode is provided (see Fig. 1B).

Following the providing step 50, an arranging step 51 of arranging one single or multiple adjacent isolation layers on the plurality of OLED segments is provided. If multiple OLED devices are to be arranged on a common substrate (not shown), it is also possible that the arranging step 51 is performed for one of the OLED devices in the form of a single isolation layer covering the respective plurality of OLED segments, while for another of the OLED device multiple adjacent isolation layers are provided, with, for example, each of these multiple isolation layers covering a respective of the OLED segments.

In a modification of the arranging step (not shown), the arranging of the one single or multiple adjacent isolation layers includes selectively removing portions from the isolation layer or layers to provide the through-hole and/or a separation of adjacent isolation layers.

Subsequent to the arranging step 51, in a contacting step 52, the respective electrodes of the OLED segments are connected with the respective the electrodes of other OLED segments by applying contacting material, forming an network of connected OLED segments (see Fig. 3A, 3B). In this embodiment, the contacting step 52 includes a sub-step 55 of selective removal of contacting material in forming the network.

As discussed above with respect to Fig. 1A to 1E, the arranging step 51 is carried out such that each isolation layer has at least one through-hole allowing for a contacting of the contacting material with the electrode of the OLED segment, the isolation layer otherwise electrically isolating the contacting material and the OLED segments, while contacting step 52 is carried out such that the contacting material contacts the electrode in the through-hole.

In step 53, an encapsulation of the OLED device by a thin film encapsulation (TFE) is provided. As this encapsulation is done in a conventional manner, further description thereof is not needed.

Fig. 5 shows a schematic illustration of a system for producing an OLED device in accordance with an embodiment of the invention.

The system 70 includes a segment providing means 71, an arranging means 72, a contacting means 73 and a controller 74 controlling the segment providing means 71, the arranging means 72 and the contacting means 73.

The details of an actual implementation of these means become sufficiently clear to the skilled person based on their functions as discussed here, so that a discussion for further structural details thereof is not necessary.

The segment providing means 71 is configured for providing a plurality of OLED segments commonly arranged on a substrate, each OLED segment comprising an OLED stack and a top electrode and a bottom electrode.

Used for arranging one single or multiple adjacent isolation layers on the plurality of OLED segments, the arranging means 72 is controlled by the controller 74 to arrange the single or multiple adjacent isolation layers such that each isolation layer has at least one through-hole allowing for a contacting of the contacting material with the electrode of the OLED segment, the isolation layer otherwise electrically isolating the contacting material and the OLED segments.

In the present embodiment, the arranging means 72 is configured such that for different OLED devices, either the single isolation layer is provided or the multiple adjacent isolation layers are provided. However, it is also possible that the arranging means is designed exclusively for one of these approaches.

The contacting means 73 is provided for electrically contacting a respective one of the electrodes of one OLED segment with a respective one of the electrodes of another OLED segment by applying contacting material such that the contacting material contacts the electrode in the through-hole.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality.

The term "through-hole" is not to be understood as defining further features other than that the through-hole of an isolation layer is an opening therein allowing for contacting material on one side to electrically contact an electrode on the opposite side of the layer, whereas the electrode and/or the contacting material may at least partially extend into the through-hole, while the opening is surrounded by the material of the isolation layer. The outer shape of the through-hole or opening may be any shape, including but not limited to circular, oval, square, rectangular and polygonal. Furthermore, it is, for example, foreseen that inside the area defined by the outer shape of the through-hole or opening one or more portions with isolating material (the same as or different from the material of the isolation layer(s) may be present.

For ease of discussion, the isolation layer is referred to here as being made of basically a homogeneous material. However, the isolation layer itself may also be a laminate or stack of different sub-layers or a compound having similar or different properties. In other words, the isolation may be inhomogeneous in its thickness direction. Furthermore, the isolation layer is preferably homogenous in its lateral direction, while nevertheless the isolation layer may also be made of a combination of patches collectively forming the isolation layer.

A single processor, device or other unit may fulfill the functions of several items recited in the claims. The mere fact that certain measures are recited in mutually different dependent claims does not indicate that a combination of these measures cannot be used to advantage.

Operations like controlling the overall production system as well as controlling or monitoring individual elements of the production system or results of production steps can be implemented as program code means of a computer program and/or as dedicated hardware.

A computer program or software product may be stored and/or distributed on a suitable medium, such as an optical storage medium or a solid-state medium, supplied together with or as part of other hardware, but may also be distributed in other forms, such as via the Internet or other wired or wireless telecommunication systems.

Any reference signs in the claims should not be construed as limiting the scope.

## Claims

1. An organic electronics device (10), comprising:
a substrate (1),
a plurality of organic electronics segments (11) commonly arranged on the substrate (1), each organic electronics segment (11) comprising an organic electronics element (13) and a top electrode (14) and a bottom electrode (12),
one single or multiple adjacent isolation layers (17) on the plurality of organic electronics segments (11), and
contacting material (19) electrically contacting a respective one of the electrodes (12, 14) of one organic electronics segment (11) with a respective one of the electrodes (14, 12) of another organic electronics segment (11),
wherein each isolation layer (17) has at least one through-hole (18) allowing for a contacting of the contacting material (19) with the electrode (12, 14) of the organic electronics segment (11), the isolation layer otherwise (17) electrically isolating the contacting material (19) and the organic electronics segments (11).

2. The organic electronics device (10) according to claim 1, wherein the one isolation layer (17) is provided on the plurality of the organic electronics segments (11) having at least one through-hole (18) for each top electrode of the plurality of organic electronics segments (11) and at least one through-hole for each bottom electrode of the plurality of organic electronics segments (11).

3. The organic electronics device (10) according to claim 2, wherein the isolation layer (17) is impermeable to moisture and/or oxygen.

4. The organic electronics device (10) according to claim 1, wherein each of the multiple isolation layers (17) is respectively provided on one or more of the plurality of organic electronics segments (11) and is separated from an adjacent isolation layer (17) provided on the same or a different of the plurality of organic electronics segments (11).

5. The organic electronics device (10) according to claim 4, wherein the multiple isolation layers (17) are permeable to moisture and/or oxygen, wherein each of the multiple isolation layers (17) further includes getter material for absorbing moisture and/or oxygen.

6. The organic electronics device (10) according to claim 1, wherein the organic electronics segments (11) of the plurality of organic electronics segments (11) are arranged in rows and columns, with the organic electronics segments (11) being electrically connected in parallel column-wise and being electrically connected in series row-wise.

7. A method for producing an organic electronics device (10), comprising the steps:
providing (50) a plurality of organic electronics segments (11) commonly arranged on a substrate (1), each organic electronics segment (11) comprising an organic electronics element (13) and a top electrode (14) and a bottom electrode (12),
arranging (51) one single or multiple adjacent isolation layers (17) on the plurality of organic electronics segments (11), and
electrically contacting (52) a respective one of the electrodes (12, 14) of one organic electronics segment (11) with a respective one of the electrodes (14, 12) of another organic electronics segment (11) by applying contacting material (19),
wherein the step of arranging (51) is carried out such that each isolation layer (17) has at least one through-hole (18) allowing for a contacting of the contacting material (19) with the electrode (12, 14) of the organic electronics segment (11), the isolation layer (17) otherwise electrically isolating the contacting material (19) and the organic electronics segments (11), and
wherein the step of contacting (52) is carried out such that the contacting material (19) contacts the electrode (12, 14) in the through-hole (18).

8. The method for producing an organic electronics device (10) according to claim 7, wherein the step of providing (50) the plurality of organic electronics segments (11) includes segmenting (54) the plurality of organic electronics segments (11) by selectively removing portions from an unstructured semi-finished arrangement of an organic electronics element (3), a top electrode (4) and a bottom electrode (2).

9. The method for producing an organic electronics device (10) according to claim 7, wherein the step of arranging (51) the one single or multiple adjacent isolation layers (17) includes selectively removing portions from the isolation layer (17) or layers (17) to provide the through-hole (18) and/or a separation of adjacent isolation layers (17).

10. The method for producing an organic electronics device (10) according to claim 7, wherein the step of electrically contacting (52) the electrodes (12, 14) includes selectively removing (55) contacting material (19).

11. A system (70) for producing an organic electronics device (10), comprising:
segment providing means (71) for providing a plurality of organic electronics segments (11) commonly arranged on a substrate (1), each organic electronics segment (11) comprising an organic electronics element (13) and a top electrode (14) and a bottom electrode (12),
arranging means (72) for arranging one single or multiple adjacent isolation layers (17) on the plurality of organic electronics segments (11),
contacting means (73) for electrically contacting a respective one of the electrodes (12, 14) of one organic electronics segment (11) with a respective one of the electrodes (14, 12) of another organic electronics segment (11) by applying contacting material (19), and
a controller (74) for controlling the segment providing means (71), the arranging means (72) and the contacting means (73),
wherein the arranging means (71) is configured to be controlled by the controller (74) to arrange the single or multiple adjacent isolation layers (17) such that each isolation layer (17) has at least one through-hole (18) allowing for a contacting of the contacting material (19) with the electrode (12, 14) of the organic electronics segment (11), the isolation layer (17) otherwise electrically isolating the contacting material (19) and the organic electronics segments (11), wherein the contacting means (73) is configured to be controlled by the controller (74) to carry out the contacting such that the contacting material (19) contacts the electrode (12, 14) in the through-hole (18).

12. A software product for producing an organic electronics device (10), the software product comprising program code means for causing a controller (74) of the system (70) according to claim 11 to carry out the steps of the method as claimed in claim 7 when the software product is run on the controller (74).
